(19)

**Europäisches Patentamt**
**European Patent Office**
**Office européen des brevets**

(11) **EP 2 957 918 B1**

(12) **EUROPEAN PATENT SPECIFICATION**

(45) Date of publication and mention
of the grant of the patent:
**29.06.2022 Bulletin 2022/26**

(21) Application number: **14879269.0**

(22) Date of filing: **18.04.2014**

(51) International Patent Classification (IPC):
**G01R 25/00** *(2006.01)*      **G01R 19/25** *(2006.01)*

(52) Cooperative Patent Classification (CPC):
**G01R 19/2513; G01R 25/00;** Y02E 40/70;
Y02E 60/00; Y04S 10/00; Y04S 10/22

(86) International application number:
**PCT/CN2014/075688**

(87) International publication number:
**WO 2015/157989 (22.10.2015 Gazette 2015/42)**

(54) **SYNCHRONOUS PHASOR MEASUREMENT METHOD APPLICABLE TO P-TYPE PHASOR MEASUREMENT UNIT (MPU)**

SYNCHROPHASOR-MESSVERFAHREN ZUR ANWENDUNG MIT EINER
P-KLASSEN-PHASOR-MESSEINHEIT

PROCÉDÉ DE MESURE DE VECTEUR TOURNANT SYNCHRONE APPLICABLE À UNE UNITÉ DE
MESURE DE VECTEUR TOURNANT (MPU) DE TYPE P

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**23.12.2015 Bulletin 2015/52**

(73) Proprietor: **North China Electric Power University
Beijing 102206 (CN)**

(72) Inventors:
• **BI, Tianshu
Beijing 102206 (CN)**
• **LIU, Hao
Beijing 102206 (CN)**

(74) Representative: **Novagraaf Technologies
Bâtiment O2
2, rue Sarah Bernhardt
CS90017
92665 Asnières-sur-Seine Cedex (FR)**

(56) References cited:
EP-A1- 2 713 172     CN-A- 102 859 334
CN-A- 103 513 105     US-A1- 2006 247 874
US-A1- 2010 250 168

• **WILLIAM PREMERLANI ET AL: "Development
and Implementation of a Synchrophasor
Estimator Capable of Measurements Under
Dynamic Conditions", IEEE TRANSACTIONS ON
POWER DELIVERY, IEEE SERVICE CENTER,
NEW YORK, NY, US, vol. 23, no. 1, 1 January 2008
(2008-01-01), pages 109-123, XP011199284, ISSN:
0885-8977, DOI: 10.1109/TPWRD.2007.910982**
• **PAOLO CASTELLO ET AL: "Performance
comparison of algorithms for synchrophasors
measurements under dynamic conditions",
APPLIED MEASUREMENTS FOR POWER
SYSTEMS (AMPS), 2011 IEEE INTERNATIONAL
WORKSHOP ON, IEEE, 28 September 2011
(2011-09-28), pages 25-30, XP032028528, DOI:
10.1109/AMPS.2011.6090351 ISBN:
978-1-61284-946-1**
• **DAS SARASIJ ET AL: "A Simple Synchrophasor
Estimation Algorithm Considering IEEE Standard
C37.118.1-2011 and Protection Requirements",
IEEE TRANSACTIONS ON INSTRUMENTATION
AND MEASUREMENT, IEEE SERVICE CENTER,
PISCATAWAY, NJ, US, vol. 62, no. 10, 1 October
2013 (2013-10-01), pages 2704-2715,
XP011526764, ISSN: 0018-9456, DOI:
10.1109/TIM.2013.2263675 [retrieved on
2013-09-11]**

**(Cont. next page)**

- DE LA SERNA J A D: "Dynamic Phasor Estimates for Power System Oscillations", IEEE TRANSACTIONS ON INSTRUMENTATION AND MEASUREMENT, IEEE SERVICE CENTER, PISCATAWAY, NJ, US, vol. 56, no. 5, 1 October 2007 (2007-10-01), pages 1648-1657, XP011192306, ISSN: 0018-9456, DOI: 10.1109/TIM.2007.904546
- PHADKE A G ET AL: "A New Measurement Technique for Tracking Voltage Phasors, Local System Frequency, and Rate of Change of Frequency", IEEE TRANSACTIONS ON POWER APPARATUS AND SYSTEMS, IEEE INC. NEW YORK, US, vol. PAS-100, no. 5, 1 May 1983 (1983-05-01), pages 1025-1038, XP011170046, ISSN: 0018-9510
- YANG, GUIFANG ET AL.: 'Synchronous Measurement Precision of Phasor Measurement Unit' AUTOMATION OF ELECTRIC POWER SYSTEMS vol. 27, no. 14, pages 57 - 61, XP008181214
- LI, SHENGFANG ET AL.: 'An Adaptive Fault Location Algorithm Based on PMU for Transmission Line' RELAY vol. 32, no. 10, pages 6 - 9, XP008181212

**Description**

**TECHNICAL FIELD**

This invention involves phasor measurement technical field, especially involves a kind of synchrophasor measurement method applying to P class Phasor Measurement Unit (PMU). A method according to the preamble of claim 1 is disclosed by William Premerlani et al. in "Development and Implementation of a Synchrophasor Estimator Capable of Measurements Under Dynamic Conditions", IEEE Transactions on Power Delivery, IEEE Service Center, New York, NY, US. Further, a dynamic phasor estimation approach is disclosed in "Dynamic Phasor Estimates for Power System Oscillations", Jose Antonio de la O Serna, IEEE Transactions on Instrumentation and Measurement, vol. 56, NO. 5, October 2007.

**BACKGROUND**

At present, the application of Phasor Measurement Unit (PMU) brings revolutionary reform for measuring technology of power system; except providing synchrophasor, the advantage with high precision and high speed uploading frequency make PMU application widely as phasor data source in the dynamic security monitoring. In the standard of IEEE C37.118.1, it requests that P class PMU can trace power system dynamic response process rapidly and accurately; there is no request for smoothing and phasor antialiasing. Therefore, the phasor measuring precision and measuring speed is crucial especially under the dynamic condition. The inaccurate or slow response speed of measuring phasor may lead to incorrect control decisions , even expand the breakdown.

The Discrete Fourier Transform (DFT) is widely used for phasor estimation in PMUs due to its low computational requirements, and also because it can extract the nominal frequency component from a waveform that is often corrupted with other harmonics.

However, the DFT is based on the assumption that the parameters of the signal do not change, and the frequency stays as a nominal value within a time window. Nevertheless, during the dynamic response process of power system, this assumption is invalid, all the parameters change with time. Therefore, two measurement problems are introduced by deficiencies in the DFT. First, spectrum leakage occurs not only due to the frequency deviation, but also due to modulation of the inputs. Second, the static phasor model results in the averaging effect of the DFT, which introduces significant errors under dynamic conditions.

With the release and the gradual improvement of the PMU standards of IEEE and China, the PMU measurement precision under dynamic condition is valued by more and more research institutions; many new technologies are applied in the measurement method. For example, some literature propose simulating three-phase phasor by the method of translation time window to eliminate the spectrum leakage of DFT under the condition of frequency deviation. But this method is only suitable for static signal input; and it can't solve the problem of spectrum leakage which is generated by dynamic signal inputs. So there is not one estimation algorithm which is based on dynamic phasor model in the existing technical solution. In addition, it can't solve the problems of spectrum leakage and average effect, which are generated by dynamic signal inputs.

BRIEF SUMMARY

The invention is defined by a synchrophasor measurement 2. method according to claim 1. Further aspects of the invention are defined in the dependent claims.

DESCRIPTION OF THE DRAWINGS

To clearly describe this technical solution of this embodiment of invention, there will be a simple introduction for the needed figures in the description of the project case. Obviously, the following described figures are only some project cases of this invention. For the general technical staff in this field, they can also get other figures according to them under without paying any creative work.

    Figure 1 is flow diagram of the synchrophasor measurement method applying to P class Phasor Measurement Unit (PMU) enumerated by the embodiment of the invention;
    Figure 2 is relationship of amplitude measuring errors and frequencies enumerated by the embodiment of the invention;
    Figure 3 is maximum TVE under different fundamental frequencies in the simulation of the frequency scan test enumerated by the embodiment of the invention;
    Figure 4 is maximum frequency and ROCOF errors under different fundamental frequencies in the simulation of the frequency scan test enumerated by the embodiment of the invention ;

Figure 5 is maximum TVE under different modulation frequencies and in the simulation of the modulation test enumerated by the embodiment of the invention;

Figure 6 is maximum frequency errors under different modulation frequencies in the simulation of the modulation test enumerated the embodiment of the invention;

Figure 7 is maximum ROCOF errors under different modulation frequencies in the simulation of the modulation test enumerated the embodiment of the invention.


## DETAILED DESCRIPTION OF EMBODIMENTS OF THE INVENTION

The technical solution of the embodiment of the invention will be described clearly and comprehensively with the figures mentioned above. Obviously, the described project cases are only parts of this embodiment of the invention, not all project cases. Based on this embodiment of the invention, all other project cases which are obtained without paying any creative work by the technical staff in this field belong to the protection range of this invention.

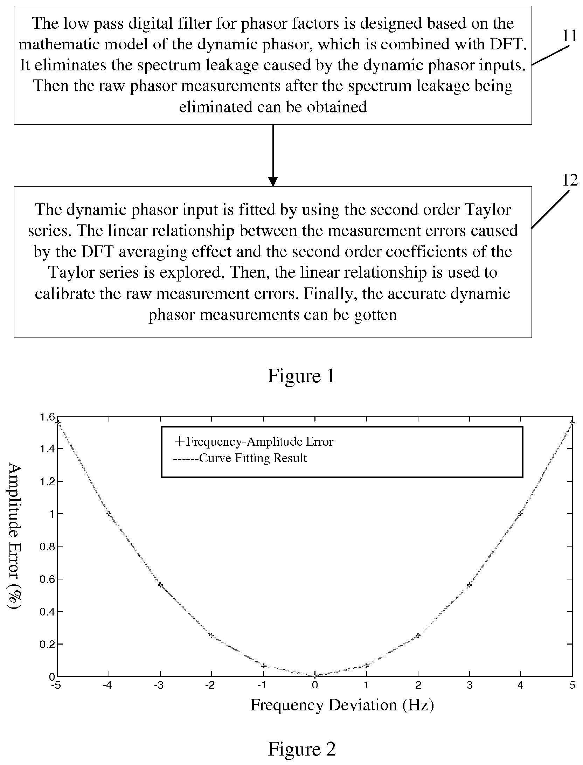

The embodiment of the invention is further described in detail with the figures. Fig. 1 is the flow diagram of the synchrophasor measurement method applying to P class Phasor Measurement Unit (PMU) enumerated by this embodiment invention. The method comprises:

Step 11: The low pass digital filter for phasor factors is designed based on the mathematic model of the dynamic phasor, which is combined with DFT. It eliminates the spectrum leakage caused by the dynamic phasor inputs. Then the raw phasor measurements after the spectrum leakage being eliminated can be obtained;

In this step, the mathematic model of the dynamic phasor is stated. For the implementation of the calculation, the mathematic model of the dynamic phasor based on the second order Taylor series is proposed. In this model, all parameters of the phasor including the amplitude, the phase angle, the frequency and the ROCOF change along with the time in the calculated time window.

For example, first, the dynamic fundamental frequency signal is now expressed as:

$$
\begin{aligned}
x(t) &= \sqrt{2} X_m(t) \cos(\int_0^t 2\pi f(t) dt + \varphi_0) \\
&= \sqrt{2} X_m(t) \cos(\int_0^t 2\pi (f_0 + \Delta f(t)) dt + \varphi_0) \\
&= \sqrt{2} X_m(t) \cos(2\pi f_0 t + (2\pi \int_0^t \Delta f(t) dt + \varphi_0))
\end{aligned} \tag{1}
$$

where $x(t)$ is the instant value of the signal, $X_m(t)$ is amplitude, $f(t)$ is signal frequency, $\varphi_0$ is the raw phase angle, $f_0$ is the nominal frequency, $\Delta f(t)$ is the frequency deviation. The amplitude and the frequency of the signal are a function of time.

Rewrite (1) as follows:

$$
\begin{aligned}
x(t) &= \text{Re}\left\{ X_m e^{j(2\pi f_0 t + (2\pi \int_0^t \Delta f(t) dt + \varphi_0))} \right\} \\
&= \text{Re}\left\{ e^{j(2\pi f_0 t)} ] X_m e^{j(2\pi \int_0^t \Delta f(t) dt + \varphi_0)} \right\}
\end{aligned} \tag{2}
$$

where Re is the real part of the formula. Then it is customary to neglect $e^{j(2\pi f_0 t)}$ in the expression above, with the understanding that the reference coordinate system synchronously rotates with the angular frequency of $2\pi f_0$. Then formula (1) is represented by $\dot{x}$, a mathematic model formula of dynamic phasor:

$$
\begin{aligned}
x(t) \longleftrightarrow \dot{X} &= X_m(t) e^{j(2\pi \int_0^t \Delta f(t) dt + \varphi_0)} = X_m(t) \angle (2\pi \int_0^t \Delta f(t) dt + \varphi_0) \\
&= X_m(t)[\cos(2\pi \int_0^t \Delta f(t) dt + \varphi_0) + j\sin(2\pi \int_0^t \Delta f(t) dt + \varphi_0)]
\end{aligned} \tag{3}
$$

The ROCOF is given by

$$
ROCOF = d/dt[f(t)] = \Delta f'(t) \tag{4}
$$

Consequently, all the parameters of the dynamic phasor are a function of time. In order to approximate the dynamic input within one time window, the second-order Taylor series is applied for all the parameters of the phasor to imitate the non-linear changing waveform, as shown in formula (5-8),

$$X_m(t) = m_2 t^2 + m_1 t + m_0 \tag{5}$$

$$\varphi(t) = n_2 t^2 + n_1 t + n_0 \tag{6}$$

$$f(t) = p_2 t^2 + p_1 t + p_0 \tag{7}$$

$$ROCOF(t) = q_2 t^2 + q_1 t + q_0 \tag{8}$$

where $m_2 = d^2 X_m(t)/dt^2|_{t=0}$, $m_1 = dX_m(t)/dt|_{t=0}$, $m_0 = X_m(0)$; $n_2 = d^2\varphi(t)/dt^2|_{t=0}$, $n_1 = d\varphi(t)/dt|_{t=0}$, $n_0 = \varphi(0)$; $p_2 = d^2 f(t)/dt^2|_{t=0}$, $p_1 = df(t)/dt|_{t=0}$, $p_0 = f(0)$; $q_2 = d^2 ROCOF(t)/dt^2|_{t=0}$, $q_1 = d\, ROCOF(t)\, /dt|_{t=0}$, $q_0 = ROCOF\,(0)$.

Then, based on the dynamic phasor mathematic model, the phenomenon of spectrum leakage caused by DFT under the dynamic phasor input condition and its impact on phasor measurements are analyzed. The DFT with the low pass digital filter is proposed to eliminate the spectrum leakage and get the raw phasor ($\tilde{X}_m^r$ and $\tilde{\varphi}$). The cut-off frequency of the low pass digital filter combined with DFT is 2.5Hz; the time window is 2 rated periods of the dynamic phasor input signal; the calculation frequency of the raw phasor is 400Hz.

For example, first, the formula of traditional DFT algorithm in current technology is:

$$\dot{X} = \frac{\sqrt{2}}{N} \sum_{k=0}^{N-1} x(k) e^{-jk 2\pi f_0 \Delta t} \tag{9}$$

Where $\dot{x}$ is the measured phasor, $N$ is the sample number, $x(k)$ is the kth sample value, $f_0$ is the rated frequency, and $\Delta t$ is the sample interval.

It can be concluded that the calculation process of the DFT is to acquire the phasor measurement by averaging the products of the signal samples and orthogonal coefficients in a time window. Then, supposing $\gamma$ is

$$\gamma = \left\{ \gamma_k \mid \gamma_k = x(k) e^{jk 2\pi f_0 \Delta t} \right\}, k = 0, 1, \cdots, N-1. \tag{10}$$

Extracting the real part and imaginary part of $\gamma$ as follows

$$C_x = \mathrm{Re}(\gamma) = XC \tag{11}$$

$$S_x = \mathrm{Im}(\gamma) = XS \tag{12}$$

where $X = \{diag[x(k); n=0,1,\ldots, N-1]\}$, $C^T = [\cos[2\pi f_0(0)\Delta t], \cos[2\pi f_0(1)\Delta t], \ldots, \cos[2\pi f_0(N-1)\Delta t]]$, $S^T = [\sin[2\pi f_0(0)\Delta t], \sin[2\pi f_0(1)\Delta t], \ldots, \sin[2\pi f_0(N-1)\Delta t]]$. Then, $C_x$ and $S_x$ are referred to the phasor factors whose properties are fundamental to the measurement characteristic of DFT. Then formula (1) can be rewritten with phasor factors, which is

$$\dot{X} = \frac{\sqrt{2}}{N} \sum_{k=0}^{N-1} C_x(k) - j S_x(k). \tag{13}$$

If the input signal is static and with nominal frequency,

$$x(t) = \sqrt{2} X_m \cos(2\pi f_0 t + \varphi_0) \tag{14}$$

Then the $\mathbf{C}_x$ and $\mathbf{S}_x$ are

$$\mathbf{C}_x(k) = x(k)\cos(2\pi f_0 k\Delta t)$$
$$= \frac{\sqrt{2}}{2} X_m \cos(4\pi k f_0 \Delta t + \varphi_0) + \frac{\sqrt{2}}{2} X_m \cos(\varphi_0) \tag{15}$$

$$\mathbf{S}_x(k) = x(k)\sin(2\pi_0 k\Delta t)$$
$$= \frac{\sqrt{2}}{2} X_m \sin(4k\pi f_0 \Delta t + \varphi_0) - \frac{\sqrt{2}}{2} X_m \sin(\varphi_0) \tag{16}$$

As shown in (15) and (16), when $k$ is increased, the phasor factors are composed of a $2f_0$ component and a direct current component. By averaging the phasor factors in one cycle of the signal, the $2f_0$ component can be eliminated, and then the real phasor can be obtained, as shown in formula (17). This is one cycle DFT algorithm.

$$\dot{X} = \frac{\sqrt{2}}{2} X_m \cos(\varphi_0) + \mathrm{j}\frac{\sqrt{2}}{2} X_m \sin(\varphi_0) = X_m \angle \varphi_0 \tag{17}$$

The DFT algorithm is widely used because of its capability of excluding harmonics and extracting the fundamental wave. However, if the frequency drifts from the nominal value, spectrum leakage will occur. In particular, when the frequency varies with time, it is hard to remove the spectrum leakage. Also, when inputting the dynamic signal, spectrum leakage will also occur.

First, use formula (1) as the input signal, then $\mathbf{C}_x$ and $\mathbf{S}_x$ will be

$$\mathbf{C}_x(k) = x(k)\cos(\omega_0 k\Delta t)$$
$$= \frac{\sqrt{2}}{2} X_m(k\Delta t)\cos[2\pi\int_0^{k\Delta t} f(t)dt + 2\pi k f_0 \Delta t + \varphi_0] + \frac{\sqrt{2}}{2} X_m(k\Delta t)\cos(2\pi\int_0^{k\Delta t} \Delta f(t)dt + \varphi_0) \tag{18}$$
$$= C_1 + C_2$$

$$\mathbf{S}_x(k) = x(k)\sin(\omega_0 k\Delta t)$$
$$= \frac{\sqrt{2}}{2} X_m(k\Delta t)\sin[2\pi\int_0^{k\Delta t} f(t)dt + 2\pi k f_0 \Delta t + \varphi_0] - \frac{\sqrt{2}}{2} X_m(k\Delta t)\sin(2\pi\int_0^{k\Delta t} \Delta f(t)dt + \varphi_0) \tag{19}$$
$$= S_1 + S_2$$

The real phasor should be like formula (3), which is composed of $C_2$ and $S_2$ of formula (18) and formula (19). However, $C_1$ and $S_1$ cannot be eliminated, since their frequencies are no longer the integer multiple of $f_0$. Therefore, spectrum leakage will occur.

As shown in formula (18) and (19), the frequencies of the frequency components that result in spectral leakage are all around $2f_0$, while the frequencies of the frequency components composing the real phasor are relatively low. According to the requirements of P-class PMU in IEEE C37.118.1 standard, $\Delta f$ and $f_1$ are all less than 2Hz, a low pass filter can be implemented to retain low-frequency components while filtering high-frequency components in phasor factors. And this is why the embodiment of the invention proposes improved DFT algorithm with the low-pass digital filter, in the purpose of eliminating spectrum leakage and obtain the initial phasor ( $\tilde{X}_m^r$ and $\tilde{\varphi}^r$). The formula is as follows:

$$\tilde{X} = \frac{\sqrt{2}}{s} \sum_{k=-\frac{N-1}{2}}^{\frac{N-1}{2}} x(k + \frac{N-1}{2}) h(k + \frac{N-1}{2}) \mathrm{e}^{-jk\omega_2\Delta t} \tag{24}$$

where $\tilde{X}$ is the calculated phasor, $h(k + \frac{N-1}{2})$ is the low-pass filter coefficients, and $s = \sum_{k=-\frac{N-1}{2}}^{\frac{N-1}{2}} h(k + \frac{N-1}{2})$. It should

be noticed that $k$ starts from $-(N-1)/2$, because the time tag position is set in the middle of the time window.

Rewriting formula (24) with the phasor factor:

$$\tilde{X} = \frac{\sqrt{2}}{s} \sum_{k=-\frac{N-1}{2}}^{\frac{N-1}{2}} h(k + \frac{N-1}{2})[\mathbf{C_x}(k) - j\mathbf{S_x}(k)]$$

$$= \frac{\sqrt{2}}{s} \sum_{k=-\frac{N-1}{2}}^{\frac{N-1}{2}} \left\{ \begin{array}{l} \frac{\sqrt{2}}{2} X_m(k\Delta t)h(k + \frac{N-1}{2}) \\ \cdot [\cos(2\pi \int_{\frac{N-1}{2}\Delta t}^{k\Delta t} \Delta f(t)dt + \varphi_0) + j\sin(2\pi \int_{\frac{N-1}{2}\Delta t}^{k\Delta t} \Delta f(t)dt + \varphi_0)] \end{array} \right\}. \qquad (25)$$

$$= \frac{1}{s} \sum_{k=-\frac{N-1}{2}}^{\frac{N-1}{2}} X_m(k\Delta t)h(k + \frac{N-1}{2})e^{j2\pi \int_{-\frac{N-1}{2}\Delta t}^{k\Delta t} \Delta f(t)dt} e^{j\varphi_0}$$

It can be seen that although the spectral leakage is eliminated, the amplitude of $\tilde{X}$ depends on $X_m(t)$, $\Delta f(t)$, and the filter coefficients. Only when $X_m(t)$ is constant and $\Delta f(t)=0$, the accurate phasor which is $\tilde{X} = X_m e^{j\varphi_0}$ can be obtained. Otherwise error of the amplitude measurement exists. But, the filter coefficients are treated as fixed for an implemented algorithm. The amplitude calculated error is only related to $\Delta f(t)$. The function between them can be assumed and approximated to a quadratic function by the curve fitting of the simulation data, what shown in Fig. 2,

$$\text{Magnitude Error} = \frac{\left\| \dot{X} \right\| - \left\| \tilde{X} \right\|}{\left\| \dot{X} \right\|} \times 100\%$$

where .

Step 12: The dynamic phasor input is fitted by using the second order Taylor series. The linear relationship between the measurement errors caused by the DFT averaging effect and the second order coefficients of the Taylor series is explored. Then, the linear relationship is used to calibrate the raw measurement errors. Finally, the accurate dynamic phasor measurements can be gotten.

In this step, first, the dynamic phasor input is fitted by using the second order Taylor series. The linear relationship between the measurement errors caused by the DFT averaging effect and the second order coefficients of the Taylor series is explored. Then, the linear relationship is used to calibrate the raw measurement errors. Finally, the accurate dynamic phasor measurements can be gotten.

Specifically, first, the coefficients of the second order Taylor series of the dynamic phasor input are calculated by least square method; and the raw frequency, the ROCOF ($\tilde{f}^r$ and $ROCO\tilde{F}^r$) and their coefficients of the second order Taylor series are gotten. All parameters of the dynamic phasor are recomputed according to the coefficients of the second order Taylor series;

Second, the raw dynamic phasor parameters are calibrated to get $\tilde{\phi}_1^r$, $\tilde{f}_1^r$ and $ROCO\tilde{F}_1^r$ ;

Then, the static compensation to the amplitude of raw dynamic phasor is made to get $\tilde{X}_{m1}^r$ according to $\tilde{f}_1^r$ ; and the dynamic measurement phasor $\tilde{X}_{m2}^r$ is obtained by the dynamic calibration.

For example, by implementation of the DFT with a low pass filter as stated in step 11, the raw phasor that is immune to the spectrum leakage is computed. However, because of the assumption that the phasor is at steady state, the raw phasor measurement is still not accurate enough with dynamic inputs, which cannot meet the requirement of the standard.

During power system oscillations, the amplitude, phase angle, frequency and ROCOF change non-linearly.

Substitute $X_m(t)$ in formula (25) with formula (5), and suppose the $\Delta f(t)=0$ for simplification of the derivation process, the formula (25) can be rewritten as:

$$\tilde{X} = \frac{1}{s} \sum_{k=-\frac{N-1}{2}}^{\frac{N-1}{2}} [m_2(k\Delta t)^2 + m_1(k\Delta t) + m_0]h(k + \frac{N-1}{2})e^{j\varphi_0}$$

$$= \frac{1}{s}e^{j\varphi_0} \{ m_2\Delta t^2 \mathbf{K_2 H} + m_1\Delta t \mathbf{K_1 H} + m_0 \mathbf{EH} \} \qquad (26)$$

$$\mathbf{K}_2 = \left[ \left( -\frac{N-1}{2} \right)^2, \left( -\frac{N-1}{2}+1 \right)^2, \cdots, 0, \cdots, \left( \frac{N-1}{2} \right)^2 \right], \quad \mathbf{K}_1 = \left[ -\frac{N-1}{2}, -\frac{N-1}{2}+1, \cdots, 0, \cdots, \frac{N-1}{2} \right],$$

where $\mathbf{E} = [1,1\cdots 1]$, $\mathbf{H} = [h(0), h(1), \cdots, h(N$

$$\mathbf{H} = \left[ h(0), h(1), \cdots, h\left(\frac{N-1}{2}\right), \cdots, h(1), h(0) \right]^T .$$

-1)$]^T$. Since the coefficients of the filter is symmetrical, so H can be expressed as

Therefore,

$$\mathbf{EH}/s = \frac{h(0)+h(1)+\cdots+h(N-1)}{h(0)+h(1)+\cdots+h(N-1)} = 1 \qquad (27)$$

$$\mathbf{K}_1\mathbf{H}/s = \frac{h(0)\left(-\frac{N-1}{2}\right)+\cdots+h\left(\frac{N-1}{2}\right)(0)+\cdots+h(0)\left(\frac{N-1}{2}\right)}{h(0)+h(1)+\cdots+h(N-1)} = 0 \qquad (28)$$

$$\mathbf{K}_2\mathbf{H}/s = \frac{h(0)\left(-\frac{N-1}{2}\right)^2 + h(1)\left(-\frac{N-1}{2}+1\right)^2 + \cdots + h(N+1)\left(\frac{N-1}{2}\right)^2}{h(0)+h(1)+\cdots+h(N-1)} = \tilde{K}_2 \qquad (29)$$

where $\tilde{K}_2$ is the weighted average of $\mathbf{K}_2$. Substitute the relative variables in formula (26) with formula (27), (28), (29),

$$\tilde{X} = (m_2 \Delta t^2 \tilde{K}_2 + m_0)e^{j\varphi_0} \circ \qquad (30)$$

Since the time tag is set in the middle of the time window, the real phasor is $\dot{x} = [m_2 (0)^2 + m_1 (0) + m_0] e^{j\varphi 0} = m_0 e^{j\varphi 0}$. Therefore, the phasor amplitude, measurement error is

$$e_m = \left| \tilde{X} \right| - \left| \dot{X} \right| = m_2 \Delta t^2 \tilde{K}_2 = \alpha m_2 \qquad (31)$$

where $e_m$ is the amplitude measurement error, $\alpha = \Delta t^2 \tilde{K}_2$. For an implemented algorithm in a device, the sample interval, the coefficients of the filter are fixed, so $\Delta t$ and $\tilde{K}_2$ are constant. Consequently, the phasor amplitude measurement error has a linear relationship with $m_2$. In addition, the slope coefficient of the linear relationship is dependent on the low pass filter.

In order to compensate the measurement error, $m_2$ needs to be calculated first. Supposing the phasor of "M" amplitude measurements calculated by formula (20) is given by

$$\begin{bmatrix} \tilde{X}_m^0 \\ \tilde{X}_m^1 \\ \tilde{X}_m^2 \\ \vdots \\ \tilde{X}_m^{M-1} \end{bmatrix} = \begin{bmatrix} 1 & 0 & 0 \\ 1 & \Delta t_c & \Delta t_c^2 \\ 1 & 2\Delta t_c & 2^2 \Delta t_c^2 \\ \vdots & \vdots & \vdots \\ 1 & (M-1)\Delta t_c & (M-1)^1 \Delta t_c^2 \end{bmatrix} \begin{bmatrix} m_0 \\ m_1 \\ m_2 \end{bmatrix}. \qquad (32)$$

where $\tilde{X}_m^r$ is the $r$th phasor amplitude measurement, $\Delta t_c$ is the phasor calculation interval. The above-mentioned formula can be written in matrix notation:

$$\tilde{\mathbf{X}}_m = \mathbf{T}_c \mathbf{C}_m \qquad (33)$$

where $\mathbf{T}$ is the coefficient matrix. The unknown matrix $\mathbf{C}_m$ is calculated by the weighted least-squares (WLS) technique:

$$\mathbf{C}_m = [\mathbf{T}_c^T \mathbf{T}_c]^{-1} \mathbf{T}_c^T \tilde{\mathbf{X}}_m . \qquad (34)$$

Again, since the time tag is set in the middle, $\tilde{X}_m^{\frac{M-1}{2}}$ is recalculated to achieve the approximated curve:

$$\tilde{X}_m^{\frac{M-1}{2}} = \left(\frac{M-1}{2}\Delta t_c\right)^2 m_2 + \frac{M-1}{2}\Delta t_c m_1 + m_0 \qquad (35)$$

Then the calculated $m_2$ is used to calibrate $\tilde{X}_m^{\frac{M-1}{2}}$ . The compensated coefficient $\alpha$ can be determined by simulation experiments.

Similarly, $n_2$ can also be calculated by this method with the measurement phasor ($\tilde{\varphi}$). Then the original frequency and ROCOF measurements are obtained by

$$\tilde{f} = n_2 \frac{M-1}{2}\Delta t_c \Big/ \pi + n_1/2\pi \qquad (36)$$

$$\widetilde{ROCOF} = n_2/\pi \qquad (37)$$

For the time changing of $\varphi(t)$, $f(t)$, and $ROCOF(t)$, their measurement errors are also linearly related with the second-order coefficients of each of their Taylor expressions. These can be verified by the simulation results,

In addition, in the specific realization process, this embodiment of the invention introduces a low pass digital filter in the traditional DFT to eliminate the spectrum leakage and the frequency aliasing phenomenon caused dynamic inputs. However, the low pass digital destroys the characteristic of traditional DFT which is being able to eliminate the integer harmonics. Therefore, the second low pass digital filter after getting the accurate dynamic phasor measurements is applied to get rid of the influence of harmonics and white noises. Then, phasor measurements with higher precision can be gotten, that is $\tilde{X}_{m3}^r$ , $\tilde{\phi}_2^r$ , $\tilde{f}_2^r$ and $\widetilde{ROCOF}_2^r$ . $N'$ is the time window length of the second low pass digital filter. Since P class PMU requires faster corresponding speed for step signals, the order of the second digital filter is lower. However, it has still enough inhibitory effect for harmonic interferences.

In the specific realization, the cut-off frequency of the second low pass digital filter is 2.5Hz. To ensure the fast dynamic responding speed, the time window is set as 27.5ms.

Specific embodiments are applied to conduct simulation test for the aforesaid measurement method. In details: The IEEE C37.118.1 standard has specified the maximum errors in phasor measurement and the static and dynamic tests to imitate the static and dynamic processes of the power system in a complete and full manner.. The proposed synchrophasor measurement method of the embodiment of the invention has been subject to the simulation test under the frequency deviation, harmonic contamination, oscillation, out of step, and fault. A comparison of the error limits of the standard is outlined to demonstrate the merit of the proposed method. For implementing the algorithm, the nominal frequency is 50Hz, the reporting rate is 50Hz, and the sample rate is 1200Hz. $N$=48, $M$=7, $N'$=10 The matrix $\mathbf{C}_m$ in formula (34) can be calculated in advance, and the look-up table method can be used when the phasor is estimated. The overall computation load for the phasor, the frequency, and the ROCOF is approximately 296 multiplications and 237 summations.

1) Frequency Scan Test

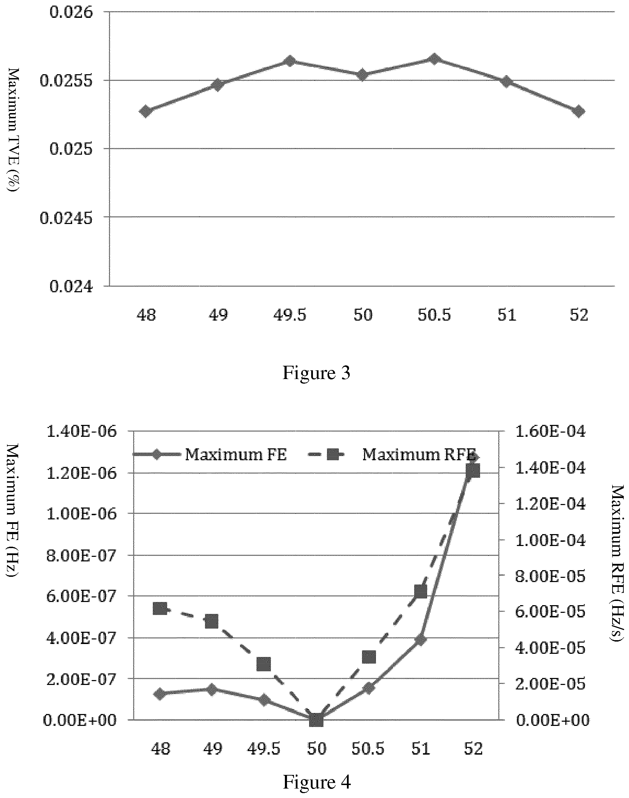

Different power system operation modes may cause the frequency to drift from its nominal value. In addition, faults can lead to major frequency excursions. In this section, the measurement accuracy of the proposed algorithm exposed to the signals with the frequency excursion is investigated.The frequency changing range of the input signal is from 48Hz to 52Hz, and remains steady during each state. In the frequency scan test of IEEE C37.118.1a, the maximum total vector error (TVE) is limited within 1%, the maximum frequency error (FE) is 0.005Hz, and the maximum ROCOF error (RFE) is 0.1Hz /s. The corresponding measurements are shown in Figure 3 and Figure 4. Figure 3 is maximum TVE under different fundamental frequencies in the simulation of the frequency scan test enumerated by the embodiment of the invention; Figure 4 is maximum frequency and ROCOF errors under different fundamental frequencies in the simulation of the frequency scan test enumerated by the embodiment of the invention. It can be observed that the proposed algorithm achieves much better accuracy than the requirements in IEEE C37.118.1a.

2) Influence of Harmonic Test

In this section, power system signal of 1% of the 2nd, 3rd, 8th and 13th harmonic under 50Hz is applied to investigate the harmonic immune capability of the proposed algorithm. The error limits in the standard (std.) are outlined in Table I as well.

The measurement results for each harmonic contamination case are outlined in Table I. It can be noted that the errors for the even order harmonics are bigger than that for the odd order ones. However, the errors are well below the required limits, which demonstrates that the proposed method is immune to harmonic contamination.

Table I Error Statistics under the Influence of Harmonics

| Fundamental Frequency (Hz) | Harmonic | Maximum TVE (%) | Maximum FE (Hz) | Maximum RFE (Hz/s) |
|---|---|---|---|---|
| | | Std.: 1 | Std.: 0.005 | Std.: 0.1 |
| 50 | 2nd | 0.005676 | 0.00016608 | 0.070205 |
| | 3rd | 0.025545 | 4.4764e-013 | 5.1082e-011 |
| | 8th | 0.0052927 | 8.2816e-005 | 0.035021 |
| | 13th | 0.025525 | 4.4764e-013 | 5.1097e-011 |

3) Modulation Test

The modulation test is applid to reflect the variations in amplitude and phase angle of the voltage waveforms when the electric power system oscillates. In general, at network node the amplitude and phase angle of positive sequence voltages shall oscillate simultaneously, with the two modulations being in phase opposition. During the test, the amplitude and the phase angle of the signal changes as a sinusoidal function. The error would be at a maximum where the non-linear extents are the most severe (the oscillation peak or valley,etc.).

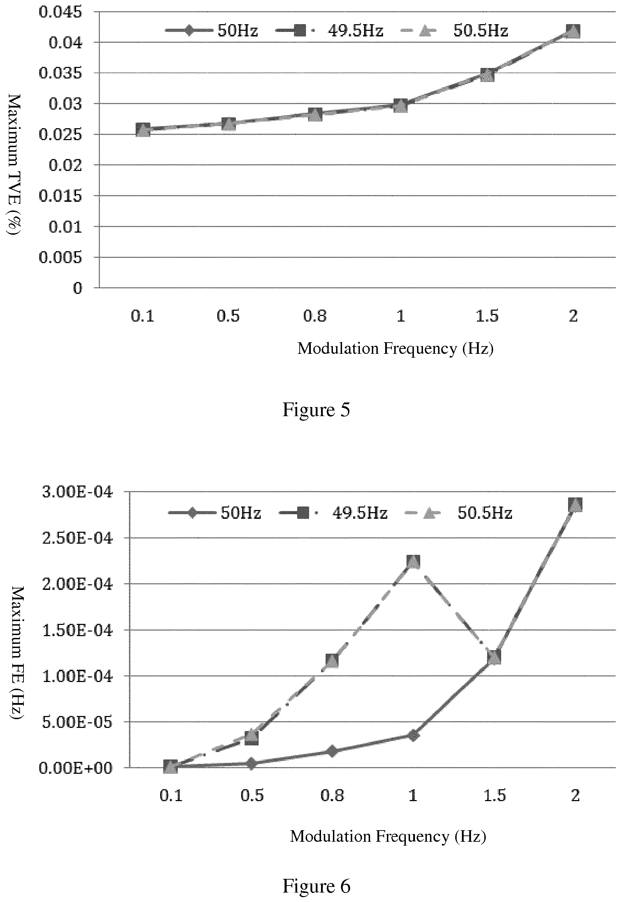

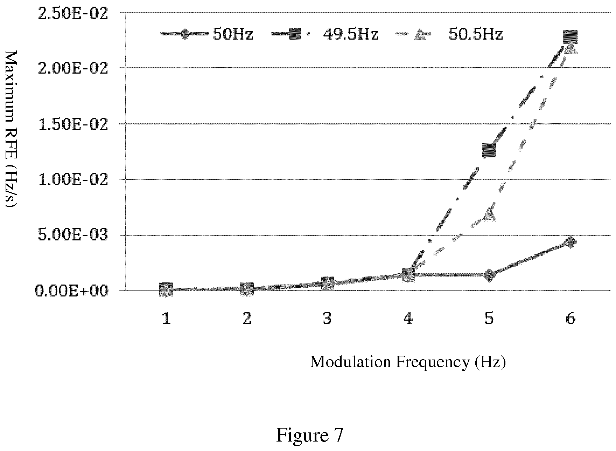

In this test, consider the amplitude modulation depth is 10%, the phase angle modulation depth is 0.1 rad, the modulation frequency varies from 0.1 Hz to 2 Hz. In the modulation test of IEEE C37.118.1a, the maximum TVE is limited within 3%, the maximum frequency error (FE) is 3Hz. The measurement errors are shown in Figure 5, Figure 6, and Figure 7. Fig. 5 shows the maximum TVE under different modulation frequency in the simulation of modulation test, as enumerated in the embodiment of the invention; Fig. 6 shows the maximum frequency error under different modulation frequency in the simulation of modulation test, as enumerated in the embodiment of the invention; Fig. 7 shows the maximum ROCOF error under different modulation frequency in the simulation of modulation test, as enumerated in the embodiment of the invention; It can be seen from Fig.5-Fig.7 that all the measurements errors continously increase as the modulation frequency grows, beacause the signal changes faster and faster within one time window. Nevertheless, the proposed algorithm exhibits a precisely dynamic tracking ability compared to the error limits in IEEE C37.118.1a.

4) Frequency Ramp Test

The frequency ramp test aims to imitate a power system out of step, which is different from the frequency scan test where the fundamental frequency of the signal is changed from 48 Hz to 52 Hz at a rate of 1 Hz/s. It can be seen from the test that the measurement method proposed by the invention can measure phasor, frequency and rate of change of frequency under continuously changing frequency accurately, as.shown in Table II.

Table II Error Statistics under the Ramp of Frequency Test

| Frequency Range | Maximum TVE (%) | Maximum FE (Hz) | Maximum RFE (Hz/s) |
|---|---|---|---|
| | Std.: 1 | Std.: 0.01 | Std.: 0.1 |
| 48Hz~52Hz | 0.0321 | 4.72e-006 | 1.32e-004 |

5) Step Test

The sudden changes in the amplitude and phase angle of the voltage and current waveforms may occur when there are faults or switching operations in power systems. For the P class PMUs, the response speed is crucial for the dynamic security monitoring of the power system.

In this test, a input signal arises a 10% amplitude step and a 10° phase angle step. The response times are shown in Table III. One can see that the response time of the phasor, can satisfy the standards requirements.

Table III Response Times under the Step Test

| Response Time (ms) | Phasor | Frequency | Frequency Change Rate |
|---|---|---|---|
| | Std.: 34 | Std.: 70 | Std.:80 |
| 10% Amplitude Step-leap | 23.7 | 42.5 | 67.5 |
| 10°Phase Angle Step-leap | 22.1 | 69 | 78 |

To sum up, the measurement method of the embodiment of the invention can compute the phasor measurements accurately during conditions of the frequency deviation, the power oscillation and the out of step. In addition, it has the fast response speed and the capability of immune to integer harmonic and non-integer harmonics.

The above description is only the best mode of the specific implementation for this invention. But the invention protection range is not limited by the specific implementation. The change or the replacement which can be done by any other technical staff who is familiar with this technical field in this technical range disclosed by the invention should be included within the protection range of the invention. Consequently, the protection range of the invention should take the claim as the standard.

## Claims

1.   A Synchrophasor measurement method Applying to P Class Phasor Measurement Unit (PMU) comprising the step of:

defining a dynamic phasor mathematic model ($\dot{x}$) for approximating a dynamic input signal ($x(t)$), so that all parameters of the dynamic phasor model are functions of time;
wherein said approximating of said dynamic input signal is performed by applying a second-order Taylor series to the parameters of the dynamic phasor model;
filtering phasor factors ($C_x$, $S_x$) of a measured phasor of the dynamic input signal with a low pass digital filter, said low pass digital filter
performing a discrete Fourier transform (DFT) so that spectrum leakage caused by the dynamic phasor inputs are eliminated;
computing a raw phasor ($\tilde{\dot{X}}$) based on the filtered phasor factors ($C_x$, $S_x$);
computing a linear relationship between raw phasor errors and the second-order coefficients of the Taylor series;
said errors being the difference between the raw phasor ($\tilde{\dot{X}}$) and the measured dynamic phasor ($\dot{x}$) after application of the second order coefficients of the Taylor series,
compensating the errors of the raw phasor ($\tilde{\dot{X}}$) by using the linear relationship when the dynamic signal *(x(t))* changes,
computing accurate dynamic phasor measurements of the dynamic input signal ($x(t)$).

2.   The method of claim 1 wherein the coefficients of the second order Taylor series of the dynamic phasor input being calculated by least square method, the raw frequency, the ROCOF and their coefficients of the second order Taylor series are calculated; and then all parameters of the dynamic phasor model are recomputed according to the coefficients of the second order Taylor series; and then
the parameters of the raw phasor ($\tilde{\dot{X}}$) are calibrated.

3.   The method of claim 1 wherein, after computing accurate dynamic phasor measurements, the measurement method also includes the step of:
filtering with a second low pass digital filter to decrease the effect of harmonics and white noise and further get phasor measurements with higher precision.

4.   The method of claim 1 wherein,
the cut-off frequency of the low pass digital filter combined with Discrete Fourier Transform (DFT) is 2.5Hz, the time window length is 2 rated periods of the dynamic input signal, the calculation frequency of the raw phasor is 400Hz.

**5.** The method of claim 3 wherein,
the cut-off frequency of the second low pass digital filter is 2.5Hz, the time window is 27.5ms.

**Patentansprüche**

**1.** Synchrophasor-Messverfahren, das auf einer P-Klassen-Phasormesseinheit (PMU) angewandt wird, umfassend die Schritte:

Definieren eines dynamischen mathematischen Phasormodells $(\dot{x})$ zum Approximieren eines dynamischen Eingangssignals *(x(t))*,
so dass alle Parameter des dynamischen Phasormodells Funktionen der Zeit sind;
wobei das Approximieren des dynamischen Eingangssignals durch Anwenden einer Taylorreihe zweiter Ordnung auf die Parameter des dynamischen Phasormodells durchgeführt wird;
Filtern von Phasorfaktoren $(C_x, S_x)$ eines gemessenen Phasors des dynamischen Eingangssignals mit einem digitalen Tiefpassfilter, wobei das digitale Tiefpassfilter
eine diskrete Fourier-Transformation (DFT) durchführt, sodass die durch die dynamischen Phasoreingänge verursachte Spektrumleckage eliminiert wird;

Berechnen eines Roh-Phasors $(\tilde{\tilde{x}})$ basierend auf den gefilterten PhasorFaktoren $(C_x, S_x)$;
Berechnen einer linearen Beziehung zwischen Roh-Phasorfehlern und den Koeffizienten zweiter Ordnung der Taylor-Reihe; wobei diese Fehler die Differenz zwischen dem Roh-Phasor $(\tilde{\tilde{x}})$ und dem gemessenen dynamischen Phasor $(\dot{x})$ nach Anwendung der Koeffizienten zweiter Ordnung der Taylor-Reihe sind,

Kompensieren der Fehler des Roh-Phasors $(\tilde{\tilde{x}})$ durch Verwendung der linearen Beziehung, wenn sich das dynamische Signal *(x(t))* ändert,
Berechnen genauer dynamischer Phasormessungen des dynamischen Eingangssignals *(x(t))*.

**2.** Verfahren nach Anspruch 1, wobei die Koeffizienten der Taylor-Reihe zweiter Ordnung des dynamischen Phasoreingangs durch die Methode der kleinsten Quadrate berechnet werden, die Rohfrequenz, der ROCOF und ihre Koeffizienten der Taylor-Reihe zweiter Ordnung berechnet werden; und dann alle Parameter des dynamischen Phasenmodells entsprechend den Koeffizienten der Taylor-Reihe zweiter Ordnung neu berechnet werden; und anschließend

die Parameter des Rohphasors $(\tilde{\tilde{x}})$ kalibriert werden.

**3.** Verfahren nach Anspruch 1, wobei nach dem Berechnen genauer dynamischer Phasormessungen das Messverfahren auch den Schritt einschließt:
Filtern mit einem zweiten digitalen Tiefpassfilter, um die Wirkung von Oberschwingungen und weißem Rauschen zu verringern und weitere Phasenmessungen mit höherer Präzision zu erhalten.

**4.** Verfahren nach Anspruch 1, wobei
die Grenzfrequenz des digitalen Tiefpassfilters in Kombination mit der diskreten Fourier-Transformation (DFT) 2,5 Hz beträgt, die Zeitfensterlänge 2 Nennperioden des dynamischen Eingangssignals beträgt, die Berechnungsfrequenz des Roh-Phasors 400 Hz beträgt.

**5.** Verfahren nach Anspruch 3, wobei
die Grenzfrequenz des zweiten digitalen Tiefpassfilters 2,5 Hz beträgt, das Zeitfenster 27,5 ms beträgt.

**Revendications**

**1.** Procédé de mesure de synchrophaseur s'appliquant à une unité de mesure de phaseur (PMU) de classe P, comprenant l'étape consistant à :

définir un modèle mathématique de phaseur dynamique $(\dot{x})$ pour une approximation d'un signal d'entrée dynamique *(x(t))*,

EP 2 957 918 B1

de sorte que tous les paramètres du modèle de phaseur dynamique sont des fonctions du temps ;
dans lequel ladite approximation dudit signal d'entrée dynamique est mise en œuvre en appliquant une série de Taylor du deuxième ordre aux paramètres du modèle de phaseur dynamique ;
filtrer des facteurs de phaseur ($C_x$, $S_x$) d'un phaseur mesuré du signal d'entrée dynamique avec un filtre numérique passe-bas, ledit filtre numérique passe-bas
mettant en œuvre une transformée de Fourier discrète (DFT) de sorte qu'une fuite de spectre causée par les entrées de phaseur dynamiques sont éliminées ;
calculer un phaseur brut $(\tilde{X})$ sur la base des facteurs de phaseur filtrés ($C_x$, $S_x$) ;
calculer une relation linéaire entre des erreurs de phaseur brut et les coefficients de deuxième ordre de la série de Taylor ; lesdites erreurs étant la différence entre le phaseur brut $(\tilde{X})$ et le phaseur dynamique mesuré ($\dot{x}$) après application des coefficients de deuxième ordre de la série de Taylor,

compenser les erreurs du phaseur brut $(\tilde{X})$ en utilisant la relation linéaire lorsque le signal dynamique (x(t)) change,
calculer des mesures précises de phaseur dynamique du signal d'entrée dynamique (x(t)).

2. Procédé selon la revendication 1 dans lequel les coefficients de la série de Taylor de deuxième ordre de l'entrée de phaseur dynamique étant calculés par un procédé des moindres carrés, la fréquence brute, le ROCOF et leurs coefficients de la série de Taylor de deuxième ordre sont calculés ; puis tous les paramètres du modèle de phaseur dynamique sont recalculés selon les coefficients de la série de Taylor de deuxième ordre ; puis

les paramètres du phaseur brut $(\tilde{X})$ sont étalonnés.

3. Procédé selon la revendication 1 dans lequel, après le calcul de mesures précises de phaseur dynamique, le procédé de mesure inclut également l'étape consistant à :
filtrer avec un deuxième filtre numérique passe-bas pour diminuer l'effet d'harmoniques et de bruit blanc et obtenir en outre des mesures phaseur avec une précision plus élevée.

4. Procédé selon la revendication 1 dans lequel,
la fréquence de coupure du filtre numérique passe-bas combiné avec une transformée de Fourier discrète (DFT) est de 2,5 Hz, la longueur de fenêtre temporelle est de 2 périodes nominales du signal d'entrée dynamique, la fréquence de calcul du phaseur brut est de 400 Hz.

5. Procédé selon la revendication 3 dans lequel,
la fréquence de coupure du deuxième filtre numérique passe-bas est de 2,5 Hz, la fenêtre temporelle est de 27,5 ms.

The low pass digital filter for phasor factors is designed based on the mathematic model of the dynamic phasor, which is combined with DFT. It eliminates the spectrum leakage caused by the dynamic phasor inputs. Then the raw phasor measurements after the spectrum leakage being eliminated can be obtained

11

The dynamic phasor input is fitted by using the second order Taylor series. The linear relationship between the measurement errors caused by the DFT averaging effect and the second order coefficients of the Taylor series is explored. Then, the linear relationship is used to calibrate the raw measurement errors. Finally, the accurate dynamic phasor measurements can be gotten

12

Figure 1

Figure 2

Figure 3

Figure 4

Figure 5

Figure 6

Figure 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Development and Implementation of a Synchrophasor Estimator Capable of Measurements Under Dynamic Conditions. **WILLIAM PREMERLANI et al.** IEEE Transactions on Power Delivery. IEEE Service Center

- **JOSE ANTONIO DE LA O SERNA.** Dynamic Phasor Estimates for Power System Oscillation. *IEEE Transactions on Instrumentation and Measurement,* October 2007, vol. 56 (5